# EUROPEAN PATENT APPLICATION

(11) **EP 4 621 629 A2**
(43) Date of publication of application: **24.09.2025**
(21) Application number: 25164893.7
(22) Date of filing: 19.03.2025
(51) Int. Cl.: G06F 30/12, G06F 16/583, G06F 30/13, G06F 30/27, G06N 3/0455, G06N 3/0464, G06V 10/82

(54) **SMART/INTELLIGENT COMPUTER AIDED DESIGN (CAD) BLOCKS**

(30) Priority: 20.03.2024 US 202463567764 P
(71) Applicant: Autodesk, Inc., San Francisco, CA 94105 (US)
(72) Inventor: Rajagopal, Anand, Sunnyvale, 94085 (US); Whitcombe, Daniel, San Francisco, 94133 (US); Yu, Yingshen, Shanghai, 200123 (CN); Chen, Danfeng, Beijing, 100062 (CN); Zou, Ping, Shanghai, 201102 (CN); Chen, Yu, Markham, L3P 2P5 (CA); Li, Bo, Shanghai, 200123 (CN); Petzel, Marina, Santa Monica, 90403 (US); Xu, Xin, Mountain View, 94040 (US); Ding, Yufeng, Shanghai, 200126 (CN); Wei, Jian An, Shanghai, 200061 (CN); Lan, Xiaofen, Shanghai, 201315 (CN); Ritter-Armour, Britta, New York, 10021 (US)
(74) Representative: Keller Schneider Patentanwaltsgesellschaft mbH

(57) **Abstract**

Embodiments of the invention provide for intelligent/smart blocks that are blocks that know what they are, are context-aware, understand their surroundings, and know to what they are similar and to what they are connected and associated. More specifically, smart blocks provide capabilities including similar block suggestions, object detection, block conversion, and smart block placement/replacement.

## Description

### CROSS-REFERENCE TO RELATED APPLICATIONS

This application claims the priority benefit of US Provisional Application Serial No. 63/567,764, filed on March 20, 2024, with inventors Anand Rajagopal, Dan Whitcombe, Yingshen Yu, Danfeng Chen, Ping Zou, Yu Chen, Bo Li, Marina Petzel, Xin Xu, Yufeng Ding, Jian An Wei, Xiaofen Lan, and Britta Ritter-Armour, entitled "Intelligent Geometry," attorneys' docket number 30566.0620USP1, which is incorporated by reference herein.

### BACKGROUND OF THE INVENTION

### 1. Field of the Invention.

The present invention relates generally to computer aided design (CAD) applications, and in particular, to a method, apparatus, system, and article of manufacture for intelligent geometry (aka smart blocks) that consist of CAD features that facilitate the creation, search, placement, replacement, and cleaning up of CAD design components.

### 2. Description of the Related Art.

When utilizing CAD applications, users commonly create "blocks" from scratch and/or utilize premade blocks. As used herein, "blocks" are a collection of objects that are combined into a single named object. In this regard, blocks are groups of geometry and metadata data typically represent real-world objects or are symbolic annotations. Blocks are often stored in CAD files (e.g., "dwg" files) and are used to create repeated content in drawings. However, the workflow for creating, using, and managing blocks can be tedious and mundane. Furthermore, such workflows are time consuming, inefficient, and fail to provide the user with assistance/help in making the right decisions and/or assist them in getting the most out of CAD tools (i.e., they fail to improve a user's proficiency in the design process). In addition, prior art workflows fail to validate and verify blocks.

Prior art systems provide various workflows to address different problems related to the creation, use, and management of blocks. More specifically, there are problems relating to detecting objects/blocks, finding objects/blocks, and placing objects/blocks. Each of these different problems are described in further detail below.

### Object Detection

Prior art systems have a general problem identifying geometry/content in a drawing that are exploded and therefore do not consist of/and are not considered blocks. In other words, prior art systems fail to provide the ability to efficiently/easily identify a group of components in a drawing that should be considered a block. Further, some prior art applications (e.g., the BRICSCAD BLOCKIFY application) appear to only be able to identify potential blocks that are exactly the same (no room for tolerance or slight differences) - as such, they are not using ML as the technical solution.

### Finding/Searchingfor Objects

To place/replace an object/block in a drawing, a user must first find/identify a desired/suitable replacement block. Prior art systems require the user to either create/design a new block from scratch, search prior files/drawings for existing blocks, and/or search a large library of existing blocks. Such prior art libraries are large and often not well organized. Thus, unfortunately, it takes an inordinate amount of time to go from an existing block in a drawing to finding a suitable replacement block in an existing library of blocks.

### Placing Object/Block

Once a suitable block has been identified, the problem arises as to how to actually insert the block into a drawing. For example, how should the block be oriented/rotated and/or scaled. In addition, the question arises as to where exactly to place the block in the drawing (e.g., should the block snap into a certain grid location, should it be placed relative to/with respect to other blocks/objects, should there be an offset to existing drawing features, etc.). Prior art systems fail to provide the ability to appropriately and efficiently provide assistance/recommendations to scale, orient, and place a block/object in a drawing.

Further to the above, once multiple blocks have been placed in a drawing, it is desirable to easily iterate changes made to all instances of a block. Further, in a larger project, a manager may want to ensure that all users are utilizing the same standard approved blocks. Prior art systems fail to provide such a capability.

In view of the above, it may be understood that prior art building information modeling (BIM) applications know what objects are, and as such, they can automate processes dependent on knowing what an object is (like cutting an opening in a wall when a door is placed in that wall, or automatically generating tags and annotations). However, to understand what model objects are, BIM programs require pre-typing or defining geometry before it is created - objects are 'heavily-typed' in BIM, meaning everything is done ahead of time and pre-determined. In BIM, the geometry representing a wall will always represent that wall, whereas with CAD, a line could be part of a wall, or a chair, or a door. This introduces rigidity when working with BIM programs and requires planning and setup before starting to create a BIM model.

In view of the above, what is needed is a CAD application that provides intelligent geometry that helps users with creating, managing, and using blocks.

### SUMMARY OF THE INVENTION

Embodiments of the invention provide for "Smart geometry" (also referred to herein as intelligent geometry or smart blocks) with geometry/blocks that have meaning. In other words, smart blocks actually *under stand* what the user intends that geometry to be. This allows CAD applications to know how to handle the geometry - how to update it, how to clean it up, validate it, link it across views and drawings. By leveraging machine learning to recognize and understand what geometry is, embodiments of the invention can take care of the redundant, mundane drafting tasks, so that CAD application users can get back to doing what they love doing and where they bring the most value - being creative and innovative.

To provide such capabilities, embodiments of the invention may take the unique approach of identifying and understanding geometry after it has been created. This allows CAD applications to maintain a quick-start and flexibility that users appreciate, while simultaneously adding the BIM benefits of understanding and assigning meaning to geometry in a drawing. Therefore, by using data, geometry, and machine learning to retroactively understand what someone has drawn, embodiments of the invention allow for: the prediction of a user's needs, next move, validation/verification capabilities, help with making decisions, etc.

Further to the above and to provide the benefits of the invention, embodiments provide smart blocks with at least four capabilities: Similar Block Suggestions, Object Detection, Block Conversion, and Block Placement/Replacement.

The present disclosure further comprises a computer-implemented system comprising a memory and at least one processor, wherein the memory comprises a set of instructions which, when executed by the at least one processor, cause the computer-implemented system to perform operations comprising the operations recited in any of the method claims and/or operations disclosed in the present description.

Yet further, the present disclosure comprises a computer program product comprising instructions which, when the program is executed by one or more computers, cause the one or more computers to carry out operations which comprise the operations recited in any of the method claims and/or operations disclosed in the present description.

Yet further, the present disclosure comprises a computer-readable medium comprising instructions which, when executed by one or more computers, cause the one or more computers to carry out operations which comprise the operations recited in any of the method claims and/or operations disclosed in the present description.

### BRIEF DESCRIPTION OF THE DRAWINGS

Referring now to the drawings in which like reference numbers represent corresponding parts throughout:
FIG. 1A illustrates a query based on shape similarity and FIG. 1B illustrates a query based on name similarity in accordance with one or more embodiments of the invention;
FIG. 2 illustrates the data extraction process in accordance with one or more embodiments of the invention;
FIG. 3 illustrates model assisted labeling in accordance with one or more embodiments of the invention;
FIG. 4 illustrates the workflow for finding similar shaped blocks in accordance with one or more embodiments of the invention;
FIG. 5 illustrates contrastive learning used by an encoder in accordance with one or more embodiments of the invention;
FIG. 6 illustrates the suggestion engine processing in accordance with one or more embodiments of the invention;
FIG. 7 illustrates further details on the block similarity architecture in accordance with one or more embodiments of the invention;
FIG. 8 illustrates the logical flow for providing similar computer aided design (CAD) blocks in accordance with one or more embodiments of the invention;
FIG. 9 illustrates a vector image with an overlaid graph of the nodes and edges in accordance with one or more embodiments of the invention;
FIG. 10 illustrates the use of a sparse transformer model as an encoder in accordance with one or more embodiments of the invention;
FIG. 11 illustrates the logical flow for enriching labels from blocks in accordance with one or more embodiments of the invention;
FIG. 12 illustrates an exemplary graphical user interface where object detection is in progress and after completion of object detection in accordance with one or more embodiments of the invention;
FIG. 13 illustrates an exemplary graphical user interface of the review/inspection mode in accordance with one or more embodiments of the invention;
FIG. 14 illustrates the logical flow for detecting computer aided design (CAD) objects in accordance with one or more embodiments of the invention;
FIG. 15 illustrates the workflow of converting detected results/instances to blocks in accordance with one or more embodiments of the invention;
FIG. 16 illustrates the ungrouping of detected results in accordance with one or more embodiments of the invention;
FIG. 17 illustrates the results of the shape-based automatic grouping algorithm in accordance with one or more embodiments of the invention;
FIG. 18 illustrates in-place conversion in accordance with one or more embodiments of the invention;

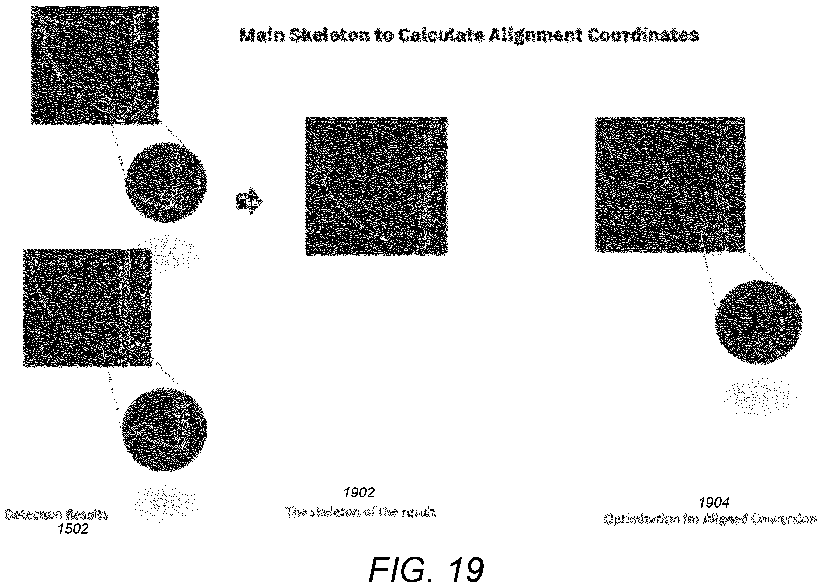

FIG. 19 illustrates the use of a main skeleton to calculate alignment coordinates in accordance with embodiments of the invention;
FIG. 20 illustrates an exemplary graphical user interface where a user has selected geometry with an option dialog to convert the selected objects into a block in accordance with one or more embodiments of the invention;
FIG. 21 illustrates an exemplary graphical user interface where the user is given the option to accept the placement or move/rotate/scale the object placement in accordance with one or more embodiments of the invention;
FIG. 22 illustrates an exemplary convert dialog box that provides the option to define a new block by specifying a block name and insertion point in accordance with one or more embodiments of the invention;
FIG. 23 illustrates the logical flow for converting geometric objects into blocks in accordance with one or more embodiments of the invention;
FIG. 24 illustrates an exemplary graphical user interface for performing block replacement in accordance with one or more embodiments of the invention;
FIG. 25 illustrates the logical flow for placing/replacing a block in a computer aided design (CAD) application in accordance with one or more embodiments of the invention;
FIG. 26 is an exemplary hardware and software environment used to implement one or more embodiments of the invention; and
FIG. 27 schematically illustrates a typical distributed/cloud-based computer system in accordance with one or more embodiments of the invention.

### DETAILED DESCRIPTION OF THE INVENTION

In the following description, reference is made to the accompanying drawings which form a part hereof, and which is shown, by way of illustration, several embodiments of the present invention. It is understood that other embodiments may be utilized and structural changes may be made without departing from the scope of the present invention.

### Overview

Embodiments of the invention provide "Smart Blocks" that consist of a series of AI/ML (artificial intelligence/machine learning) based features that help users create, find, place, replace, and clean up their CAD design components - blocks.

Previously, the problems of the prior art were not approached from a data/AI driven manner. Some prior art applications looked to match exact geometry. However, embodiments of the invention extend deeper to ascertain similarities based on the semantic meaning of the block in its context. Further, embodiments of the invention are based on cutting edge industry research in computer vision of raster images and Geometric Graph Neural Networks. Further, embodiments of the invention extend prior work towards CAD data.

More specifically, embodiments of the invention provide intelligent geometry/geometric intelligence that makes CAD geometry smart, connected, and context-aware resulting in the automation of time-consuming, mundane processes, guided user workflows, the ability to aid in decision making, and the unlocking of complete design proficiency.

### Smart Blocks

As described above, blocks are a standard CAD concept. They are groups of geometry and metadata that typically represent real-world objects or are symbolic annotations.

Embodiments of the invention provide for intelligent/smart blocks that are blocks that know what they are, are context-aware, understand their surroundings, and know to what they are similar and to what they are connected and associated.

Smart blocks provide the ability to guide users to help them make the right decisions, assist them in getting the most out of CAD tools, and alleviate their tedious and mundane workflows related to creating, using, and managing blocks. To provide such capabilities, embodiments of the invention utilize ML to recognize objects, their context, etc.

The question arises regarding the purpose for smart blocks. In this regard, smart blocks save time, optimize and automate tedious, time-consuming, mundane processes/workflows and next steps (e.g., contextual updates, auto-generate schedules, etc.), help make decisions, and validate and verify (applications, objects, blocks). In addition, smart blocks are just about efficiency. Smart blocks also enhance the proficiency of users with respect to CAD applications and CAD application tools. Intelligent/smart geometry guides users, and helps them make the best decisions so that they can maximize and optimize their design potential.

As described above, smart blocks provide various capabilities including similar block suggestions, object detection, block conversion, and smart placement. Each of these capabilities are described in further detail below.

### Similar Block Suggestions

To facilitate the creation and replacement of blocks in a drawing, embodiments of the invention generate similar block suggestions to help users find the block they are looking for when replacing and creating blocks. In this regard, the meaning/intent of a block may be inferred by knowing what other blocks it is similar to. As part of the process of determining similar block suggestions, embodiments of the invention may also provide the ability to group, categorize, and classify similar blocks. To provide such capabilities, embodiments of the invention utilize ML to determine similar blocks based on shape, visual geometry, and naming (metadata). Details for such capabilities are described below.

Block Replacement uses shape and name similarity ML models. A shape similarity model receives a raster-based block image. A name similarity model receives metadata information associated with the block (block name, drawing name, file path).

The ML model outputs are embeddings from shape and name similarity models, which later are combined together using a suggestion engine. The return/output from the suggestion engine identifies the top similar blocks for a given query block.

The training data for the shape similarity model consists of labeled images, where each image has a class label (such as sink, single door etc.). The majority of training data represents blocks from architectural and engineering industries. The model learns to group similar blocks closer together in the feature space while separating dissimilar ones, using these labels to guide the learning process. The data used for the name similarity model represents block metadata information extracted from drawing (e.g., dwg) files.

### Block Similarity

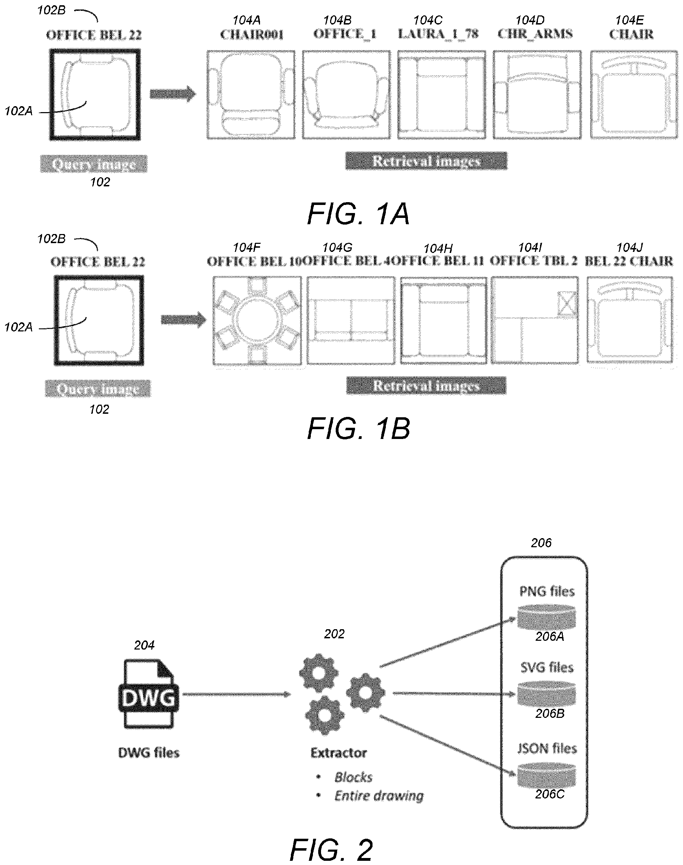

The block similarity can include/are based on both name similarity and shape similarity. FIG. 1A illustrates a query based on shape similarity while FIG. 1B illustrates a query based on name similarity in accordance with one or more embodiments of the invention. More specifically, the query image 102 is the same in FIG. 1A and FIG. 1B and includes both the image 102A and the name 102B (i.e., "OFFICE BEL 22"). In FIG. 1A, similarity is based on the shape 102A and as a result, different similar images 104A-104E are retrieved. In FIG. 1B, the text 102B "OFFICE BEL 22" is compared to the text (e.g., in the metadata of other objects/blocks) to find similar names (e.g., OFFICE BEL 10 104F , OFFICE BEL 4 104G , OFFICE BEL 11 104H, OFFICE TBL 2 104I, and BEL 22 CHAIR 104J).

In embodiments of the invention, the ML solution differs based on the query type. For example, a shape similarity ML model may be used to determine similar shapes as in FIG. 1A. Further, a block name similarity ML model may be used to determine similar models based on name as in FIG. 1B. In addition, a suggestion engine may combine both shapes and names (i.e., utilize both the shape similarity ML model AND the block name similarity model) to determine the most similar shape/blocks.

### Data Collection

Collecting data from drawing files is the first step in finding similar blocks. The first step in data collection is that of extracting the data. FIG. 2 illustrates the data extraction process in accordance with one or more embodiments of the invention. As illustrated an extractor 202 extracts key information from raw drawing (e.g., DWG) files 204 including: user-defined blocks and all geometries (e.g., entire drawings). The extractor 202 then outputs the extracted data into a variety of data formats 206 (e.g., PNG files 206A, SVG files 206B, JSON files 206C, etc.).

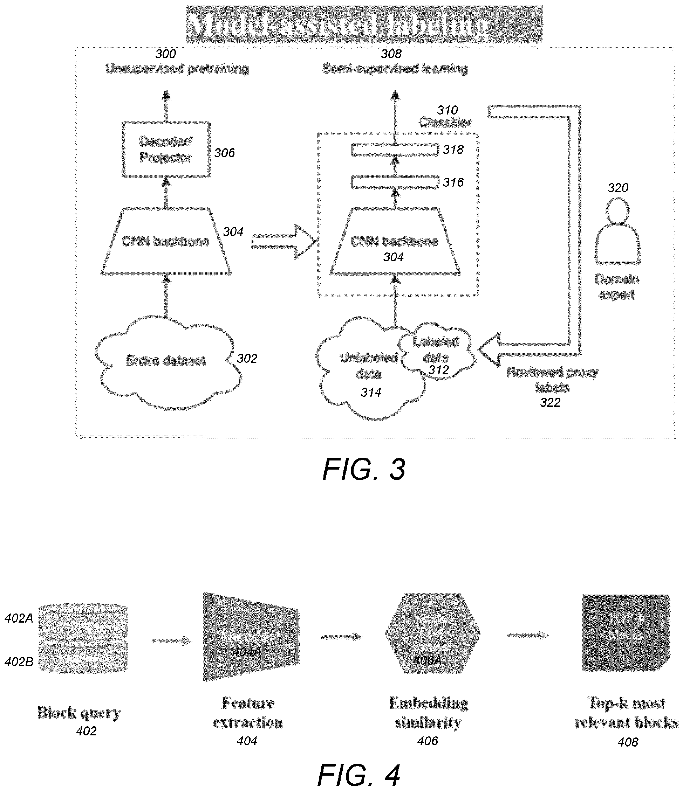

Once extracted, embodiments of the invention perform model assisted labeling. FIG. 3 illustrates model assisted labeling in accordance with one or more embodiments of the invention. As a first step, during unsupervised pre-training 300, a convolutional neural network (CNN) backbone 304 is pretrained on an entire dataset 302 (e.g., a dataset of existing files with known/unknown blocks/geometry). The CNN process may utilize the decoder/projector 306 to deconstruct/reconstruct a compressed image into its original form (i.e., from an encoded image). In this regard, the decoder/projector 306 may be utilized to perform image-to-image regression tasks and/or to learn how to map similar blocks (i.e., between images).

Once trained using unsupervised pre-training, embodiments of the invention may perform a semi-supervised learning process 308. During the semi-supervised learning, a CNN classifier 310 (builds upon the CNN backbone 304) is trained on a small labeled dataset 312 and a large unlabeled dataset 314.

The CNN classifier 310 generates/provides proxy labels 316-318 for unlabeled samples.

Lastly, the proxy labels 316-318 are reviewed by a domain expert 320 and the reviewed proxy labels 322 are then included in/added to the labeled dataset 312.

### Similar Block Workflow

FIG. 4 illustrates the workflow for finding similar shaped blocks in accordance with one or more embodiments of the invention. At the first step, a block query 402 is received. The block query 402 consists of image 402A and metadata 402B that the user is trying to find.

Feature extraction 404 is then performed on the block query 402. More specifically, the features in the block query 404 are extracted using an encoder 404A.

The next step is that of similarity embedding 406. During step 406, similar blocks are retrieved (i.e. similar block retrieval 406A) (from a block library).

At step 408, the top-k most relevant blocks are identified/selected. In other words, once similar blocks are retrieved at 406, the similar blocks that meet/exceed a certain threshold (i.e., the top-k most relevant blocks) are selected.

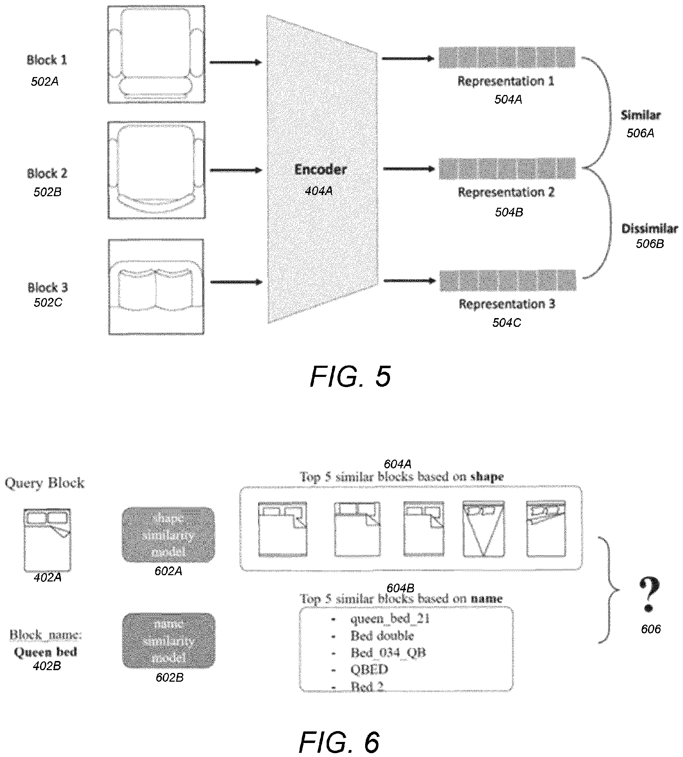

FIG. 5 illustrates contrastive learning used by the encoder 404A in accordance with one or more embodiments of the invention. As illustrated, block 1 502A, block 2 502B and block 3 502C are processed by encoder 404A to generate different representations (i.e., representation 1 504A, representation 2 504B, and representation 3 504C). The different representations 504A-504C may be ranked/ordered by similarity/dissimilarity as indicated at 506A and 506B.

FIG. 6 illustrates the suggestion engine processing in accordance with one or more embodiments of the invention. More specifically, the query block 402 consists of the image 402A and the block name/metadata 402B. Each query block 402A/402B is processed respectively by the different ML models (e.g., shape similarity model 602A is used to process image 402A, and name similarity model 602B is used to process block name/metadata 402B). The output from the different models 602A/602B provides the top five (5) similar blocks based on shape 604A and name 604B. Embodiments of the invention then combine the two resulting in output 606 with the most similar blocks based on both shape AND name.

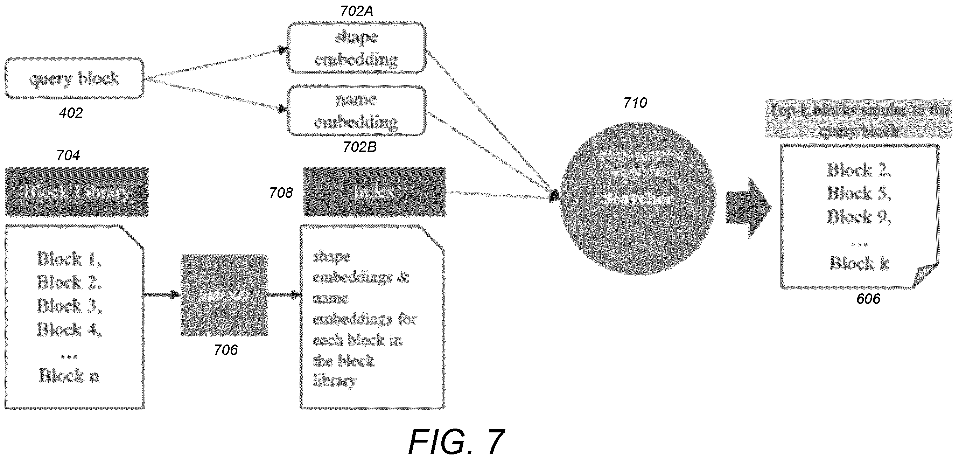

FIG. 7 illustrates further details on the block similarity architecture in accordance with one or more embodiments of the invention. As illustrated, the query block 402 is received and is broken up into the shape embedding 702A and name embedding 702B (i.e., both the shape/image 702A and the name/metadata 702B is embed/encoded). The block library 704 (consisting of multiple blocks) is processed via an indexer 706 to generated indices 708 (e.g., that consist of shape embeddings and name embeddings for each block in the block library 704).

The embedded shape 702A, name 702B, and indices 708 are input into a (query-adaptive algorithm) searcher 710. The searcher 710 then identifies the top-k blocks 606 that are similar (in terms of both shape and name) to the query block 402 (e.g., blocks 2, 5, 9, ...k).

In view of the above, embodiments of the invention are able to use machine learning to search a block library 704 and identify the top-k number of blocks 606 that are similar in terms of both shape and name to a query block 402.

### Logical Flow

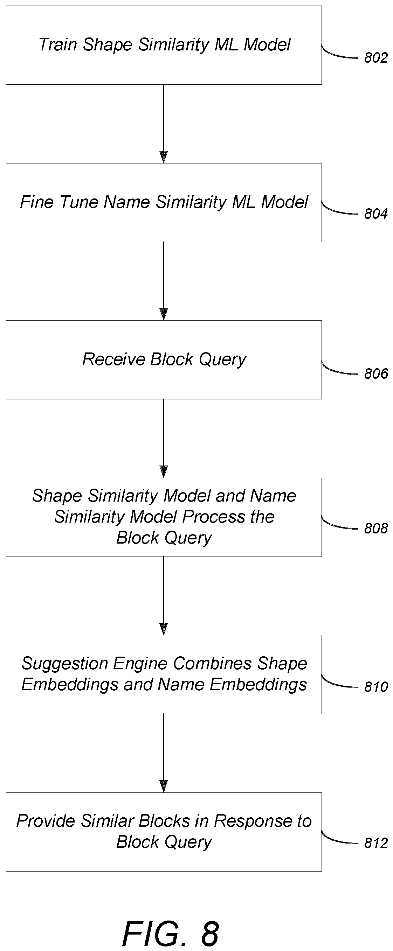

FIG. 8 illustrates the logical flow for providing similar computer aided design (CAD) blocks in accordance with one or more embodiments of the invention.

At step 802, a shape similarity machine learning (ML) model is trained based on labeled images. The labeled images consist of/comprise blocks from architectural and engineering industries. Each labeled image is a class label. The shape similarity model groups blocks together based on shape using the class label to guide learning.

At step 804, a name similarity ML model is/consists of a transformer based model (Sentence-BERT) fine tuned based on block metadata information extracted from one or more drawing files wherein the name similarity model groups blocks together based on name.

In one or more embodiments, the shape similarity model is generated using a convolutional neural network (CNN) and the name similarity model is generated using a tranformer model.

At step 806, a block query for a block is received. The block query includes: (i) a raster-based block image; and (ii) metadata information associated with the block. In one or more embodiments, the metadata includes a block name, a drawing name, and a file path.

At step 808, the shape similarity model processes the raster-based block image and the label to output shape embeddings. Further, in step 808, the name similarity model processes the metadata information associated with the block to output name embeddings. In one or more embodiments, the shape similarity model processes the raster-based block image using an encoder that extracts features from the labeled images.

At step 810, a suggestion engine combines the shape embeddings and the name embeddings to identify similar blocks. In one or more embodiments, the suggestion engine: orders the identified similar blocks based on similarity; selects, based on the order, a defined number of most relevant identified similar blocks; and provides the defined number of most relevant identified similar blocks in response to the block query.

At step 812, the identified similar blocks are provided in response to the block query.

### Object Detection

An additional feature of embodiments of the invention is that of object detection. Such a feature leverages machine learning to scan a drawing for objects that can be converted into blocks. In particular, groups of geometry are identified in a CAD drawing as objects (e.g., a rectangle plus an arc along a horizontal line is a door). The purpose of such object detection is to convert identified objects into blocks. Once converted into blocks, users can realize the efficiency and best practice benefits of using blocks. Embodiments of the invention utilize an ML model to perform such object detection.

A CAD drawing image is first obtained and then converted into a graph. The graph contains geometric tokens as nodes, a geometry token is a set of features extracted from a geometry, and for each geometric token, edges are constructed between the token and its K nearest neighbor tokens, determined by the distance. The graph is then input to an ML model. Thus, the input data (into the ML model) are graphs of the geometric tokens. The output from the ML model consists of the node's masks of each predicted object. Each mask consists of an index list of the nodes/geometric tokens that form an object in the CAD drawing.

### Data Collection

Similar to that used to similar block suggestions, FIG. 2 illustrates the workflow for data collection utilized for object detection in accordance with one or more embodiments of the invention. In one or more embodiments, the different file formats may be utilized for different purposes. For example, PNG files 206A may be used for pixel-based solutions, SVG files 206B may be used for vector-based solutions, and JSON files 206C may be used for metadata.

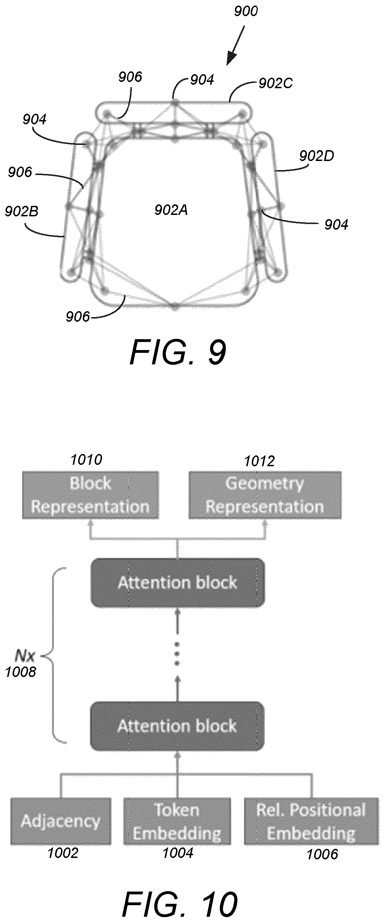

FIG. 9 illustrates a vector image with an overlaid graph of the nodes and edges in accordance with one or more embodiments of the invention. As illustrated the vector image 900 contains 2D primitive geometries 902A-902D that have been converted into nodes 904 (representing the geometric tokens) and edges 906 linking to the K nearest neighboring data points/nodes 904. In this regard, the data transformation of the vector image 900 includes the conversion of the 2D primitive geometries 902A-902D (e.g., in SVG files) into geometric tokens/nodes 904.

Once the graph with nodes and edges have been received, embodiments of the invention then encode the data represented by the graph. More specifically, a sparse transformer model is utilized as an encoder that contains an attention mechanism among the nodes in the graph. During attention computation, each node updates its embeddings by aggregating the embeddings of its neighbors in the graph. FIG. 10 illustrates the use of a sparse transformer model as an encoder in accordance with one or more embodiments of the invention. As illustrated, the adjacencies 1002, geometric token embeddings 1004, and relative positional embeddings 1006, are encoded, via a series of Nx attention blocks 1008, into block/object representations 1010 and geometry representations 1012 for a variety of tasks.

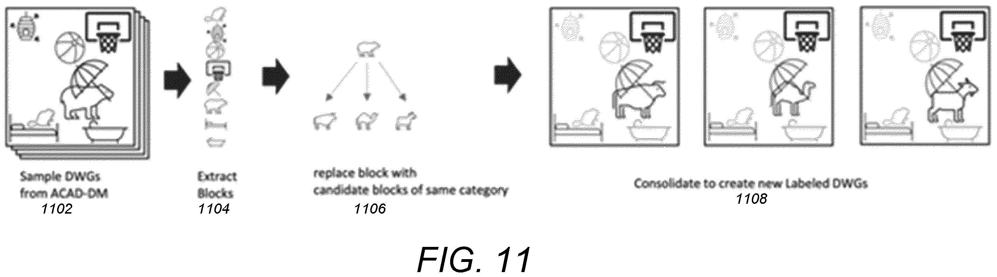

Further to the above, as part of the object detection, labels from the blocks may be enriched. FIG. 11 illustrates the logical flow for enriching labels from blocks in accordance with one or more embodiments of the invention. As illustrated, sample drawings (e.g., from AUTOCAD-DM^{™} - a CAD design and document management system) are received at 1102. At step 1104, blocks are extracted from the drawings. At step 1106, the extracted blocks are replaced with candidate blocks of the same category. At step 1108, the newly replaced blocks are consolidated to create new labeled drawings.

### User Interface

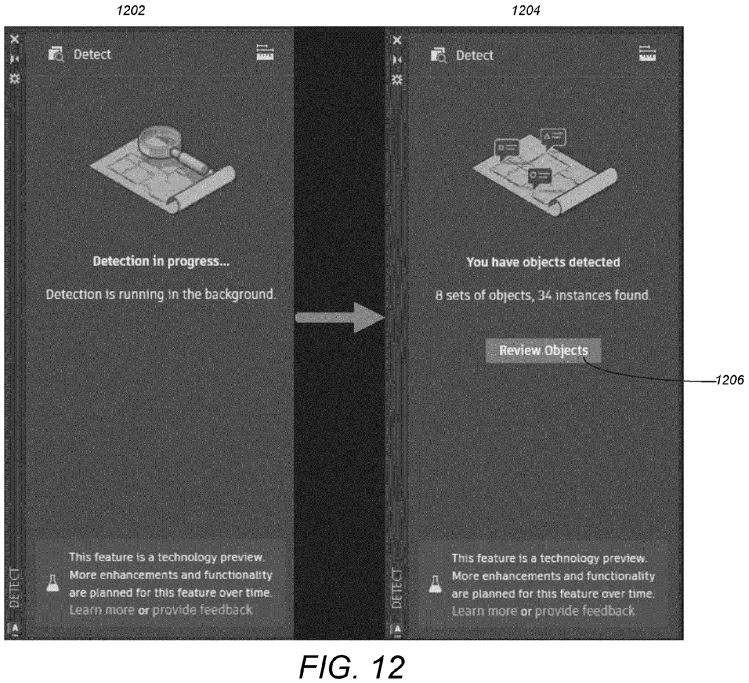

When the object detection workflow begins, the drawing content is sent to an ML service for recognition. The detection results may then be displayed in a window/palette. FIG. 12 illustrates an exemplary graphical user interface where object detection is in progress at 1202 and after completion at 1204 where 8 sets of objects and 34 instances have been found.

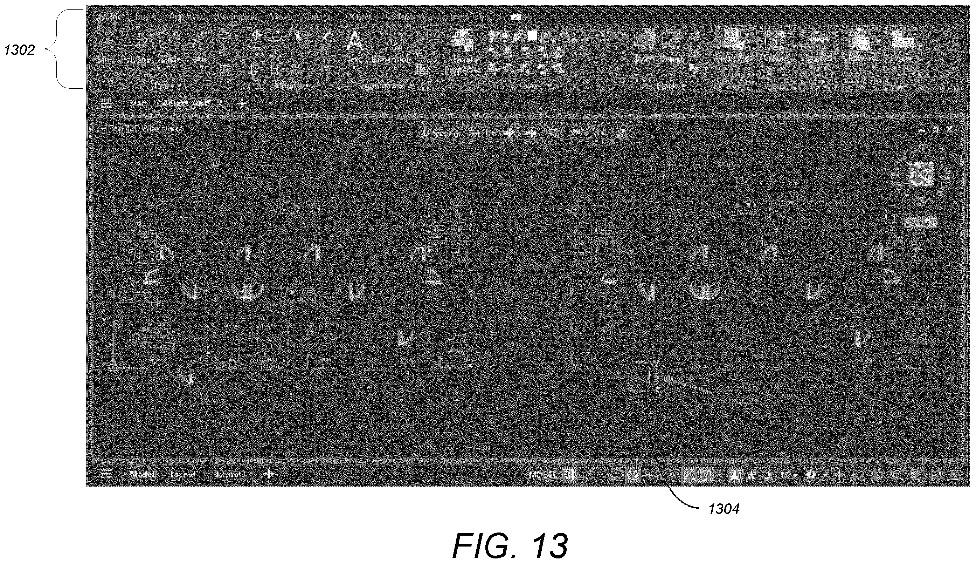

After detection, users may then have the option to inspect identified instances (e.g., by clicking a "Review Objects" icon/button 1206). FIG. 13 illustrates an exemplary graphical user interface of the review/inspection mode in accordance with one or more embodiments of the invention. During the review/inspection mode, a toolbar 1302 may be displayed that provides various options for navigating through the different sets and managing detected objects. A "set" consists of a group of instances that collectively represent the same real-world object (for example, door). Within each set, the primary instance 1304 (that may be displayed in a visually distinguishable manner such as with a blue border) defines the object and orientation when converting the detected instances into new blocks. Users may encounter incorrect sets or instances during the detection review. Further, if a similar object is not detected and included in the set, the user may report such an error (i.e., via a feedback loop back to the ML service), thereby contributing to improving the overall performance and accuracy of the ML service.

### Logical Flow

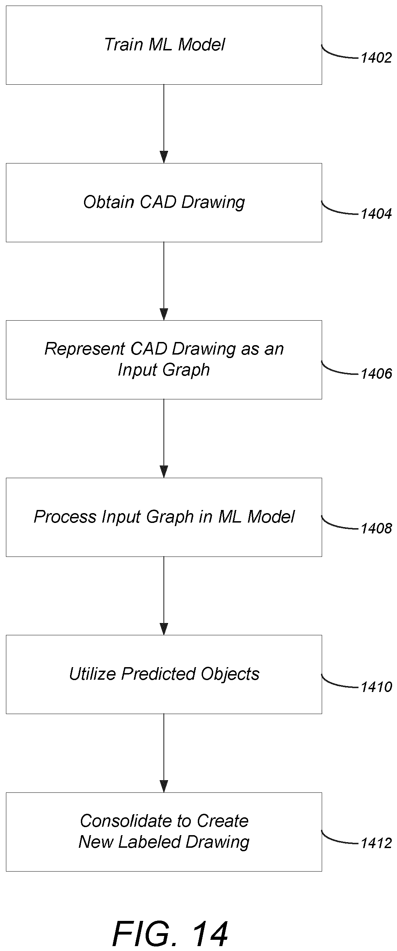

FIG. 14 illustrates the logical flow for detecting computer aided design (CAD) objects.

At step 1402, a machine-learning (ML) model is trained to process graphs representing the CAD objects. The training is based on ground truth labels and ground truth CAD objects. In one or more embodiments, the ML model uses a sparse transformer model as an encoder. Such a sparse transformer model encodes the geometric tokens and positional embeddings into object/block representations and geometry representations.

At step 1404, a CAD drawing is obtained and consists of/includes two-dimensional (2D) geometric primitive geometries.

At step 1406, the CAD drawing is represented as an input graph. The 2D geometric primitive geometries are represented by geometric tokens in nodes of the input graph. Spatial KNN (k nearest neighbor) adjacency between the 2D geometric primitive geometries are represented as edges between the nodes of the input graph.

At step 1408, the input graph is processed in/by the ML model. Pursuant to the processing, the ML model outputs nodes representing predicted objects for the 2D geometric primitive geometries.

At step 1410, the predicted objects are utilized to represent the 2D geometric primitive geometries.

At step 1412, the predicted objects are consolidated to create a new labeled drawing.

Further to the above, the ML model may be updated via a feedback loop based on confirmation of the predicted blocks from user input.

### Block Conversion

Block conversion is the process to easily convert a group of geometric entities (e.g., detected objects) into an instance of a block definition. Such block conversion is used to cleanup drawings, avoid duplicate block definitions, help easily and quickly create blocks, etc. More specifically, one or more embodiments of the invention allow a user to convert multiple similar groups of geometry/objects into instances of either a new block definition or an existing block definition. The process includes providing suggestions of existing block definitions that are similar to the unblocked geometry so that users can easily and conveniently re-use their existing blocks. This encourages efficiency, saves the user time, reinforces good block hygiene and best practices.

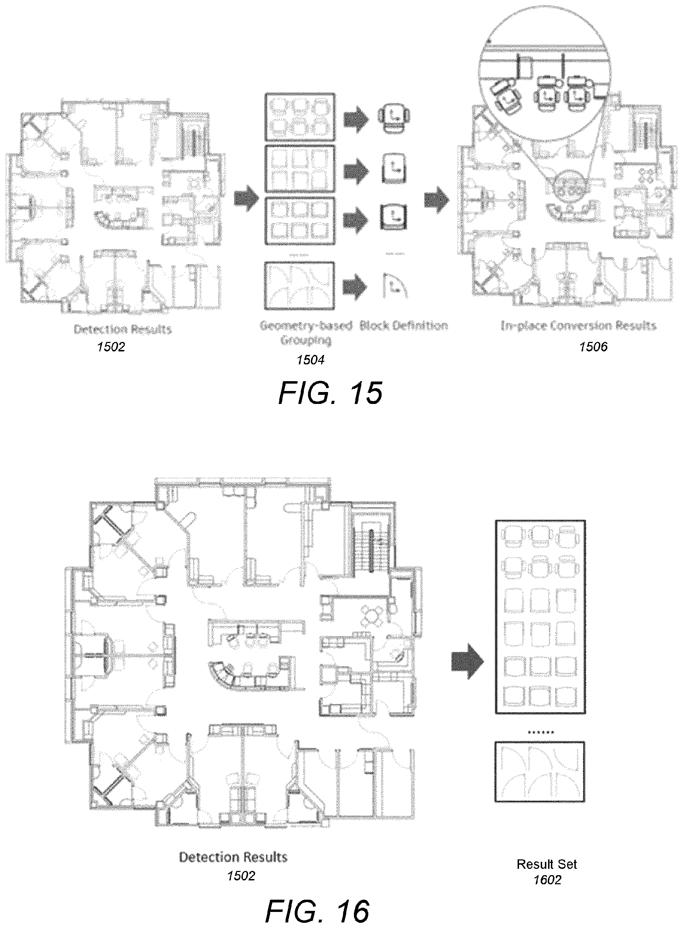

FIG. 15 illustrates the workflow of converting detected results/instances to blocks in accordance with one or more embodiments of the invention. At step 1502, the detection results (e.g., as described above with respect to object detection) are obtained. At step 1504, geometry-based block definition grouping is performed (i.e., the detected geometry/objects are grouped into potential blocks). At step 1506, in-place conversion is performed on the groupings. A more detailed breakdown/description of this workflow is described below.

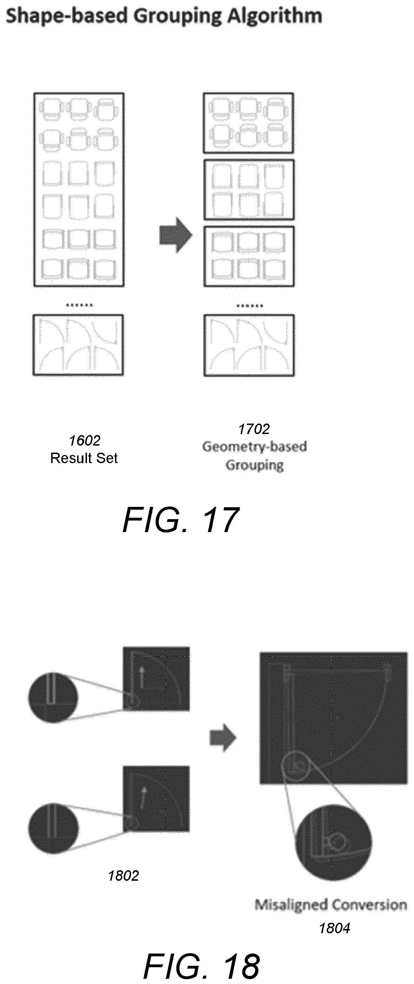

Detection results from the ML model are individual objects described by a list of geometry indices (further accurate shape grouping/rotation estimation is needed for determining the block definitions). For example, chairs in result set 1602 may look different in a result set and aren't grouped based on shape similarity. Accordingly, embodiments of the invention may classify detected geometry/object results by shape. More specifically, embodiments of the invention may perform shape-based automatic grouping (i.e., using a fault-tolerant shape-based automatic grouping algorithm) for post-processing of the ML results (from the object detection). As illustrated in FIG. 17, the results with different shapes in one result set 1602 will be classified based on shape similarity 1702.

The algorithm may be designed to effectively address shape similarity-based optimal classification challenges, particularly when geometric data is limited. Key ideas for the shape-based automatic grouping algorithm include: Principal Features Extraction; Enriched Geometric Feature Data; and Optimal Group Number Determination.

One of the approaches of the shape-based automatic grouping algorithm is that of preparing geometric feature data. Such preparation may include: increasing the number of sampling vertices on geometries for richer information; utilizing PCA (Principal Component Analysist) computation using all vertices for Eigenvalues calculation (similar shapes have similar Eigenvalues); and including the length of geometries and the ratio of the perimeter to the circumference of their smallest enclosing circle.

Another feature of the shape-based automatic grouping algorithm is that it classifies (the geometry/objects) based on the geometric feature data. Such classification may: utilize k-means clustering for classifying the feature data from entities; determine the optimal number of clusters by evaluating results with increasing k-values; use the Silhouette algorithm to assess the quality of classification; address premature iteration exit due to local optimal solutions with a compactness-based judgment condition; and enhance stability using an augmented Bikmeans algorithm, eliminating uncertainty from random sampling of the initial cluster center.

FIG. 17 illustrates the results of the shape-based automatic grouping algorithm in accordance with one or more embodiments of the invention. As illustrated, the result set 1602 are processed by the algorithm to generate geometry-based grouping (i.e., grouping of objects based on their geometry/shape).

The quality of recognition results returned by machine learning models is sometimes suboptimal due to factors such as insufficient training data and the complexity of the recognition scenes. There are two main issues: first, some parts of the object that should be recognized are missed, while other parts that should not be recognized are incorrectly identified as part of the object; second, the recall issue, where some objects that should be recognized are not identified by the model. This results in small differences and missing objects within the same group after grouping the ML results by shape. Therefore, the recognition results need to be corrected during post-processing. In embodiments of the invention, a voting strategy is employed to correct discrepancies among different objects within the same group. Specifically, if an identified object is missing certain parts compared to other objects in the group, and those parts are present in the current drawing, the missing parts are added to the results. Conversely, if a recognized object contains parts that are not present in other objects within the group, those extraneous parts are removed from the results. After completing the corrections for objects within the same group, all objects will have exactly the same shape. Then, a geometric search algorithm is used to identify objects in the drawing that share the same shape but were not recognized by the ML model, and these objects are added to the group.

### User Interface

As described above, a feature of smart blocks includes the ability to easily convert multiple instances of specified geometry into blocks. In this regard, when a user specifies geometry for conversion, embodiments of the invention may identify (e.g., via object detection as described above) and highlight all instances of the same geometry. Thereafter, the user can choose to convert the source object or the instances into a block.

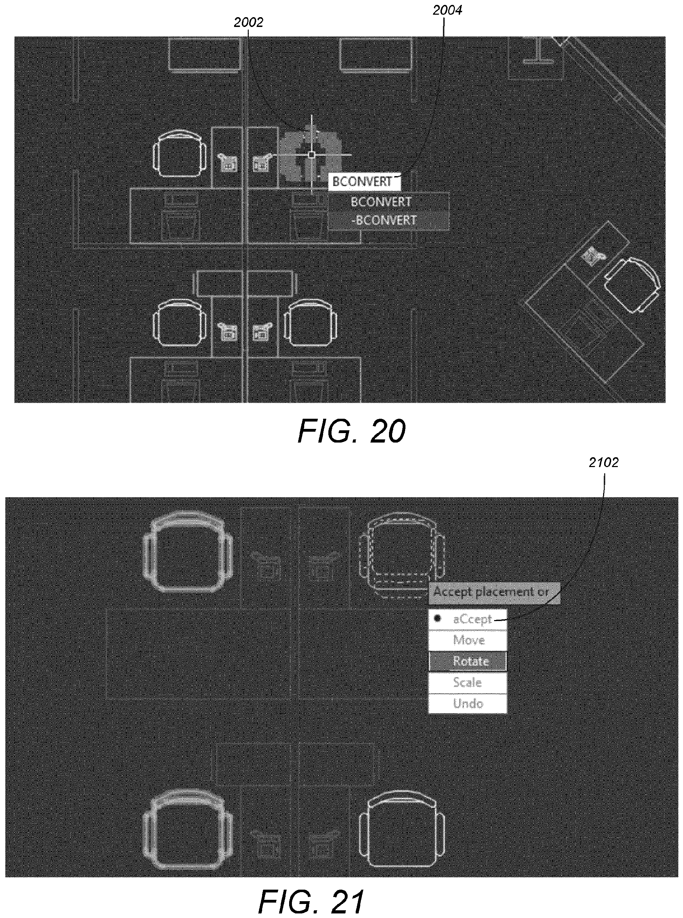

FIG. 20 illustrates an exemplary graphical user interface where a user has selected geometry 2002, all other instances of the geometry have been highlighted, and the user is given the option 2004 to convert the selected objects into a block.

When converting to an existing block, there may be several options: a user can pick a block from the drawing or choose from a recently used block, a block from the list of blocks in the current drawing, or a block that already exists in a library, or pick directly from the drawing canvas, choose a recently used block, or a similar block that already exists in the library suggested by the ML algorithm (as described above). After selecting an existing block definition, the alignment of the block may be adjusted relative to the source geometry. FIG. 21 illustrates an exemplary graphical user interface where the user is given the option 2102 to accept the placement or move/rotate/scale the object placement.

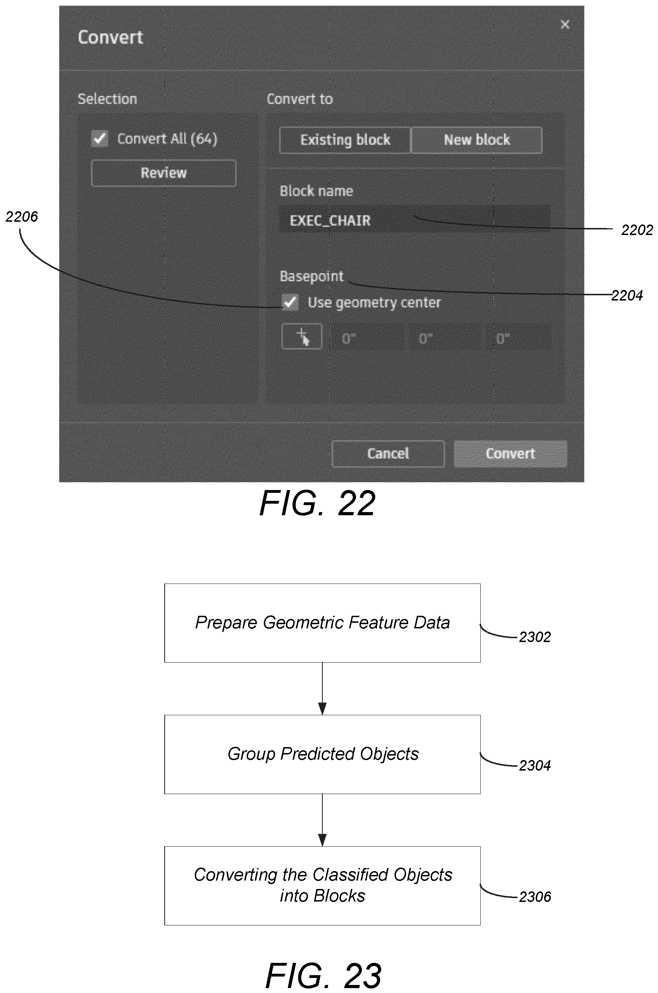

Alternatively, embodiments of the invention may convert the source object or the selected instances to a new block. FIG. 22 illustrates an exemplary convert dialog box that provides the option to define a new block by specifying a block name 2202 and insertion point 2204 in accordance with one or more embodiments of the invention. By default, the insertion point may be set to the center 2206 of the specified geometry. The ability to quickly convert repetitive geometry into blocks minimizes redundancy in the design process and provides a wider range of options for organizing drawings.

### Logical Flow

FIG. 23 illustrates the logical flow for converting geometric objects into blocks in accordance with one or more embodiments of the invention.

At step 2302, geometric feature data is prepared from the predicted objects. This step may include: increasing a number of sampling vertices on geometries; utilizing principal component analysis (PCA) computation using all the sampling vertices for Eigenvalue calculations; and including a length of the 2D geometric primitive geometries and a ratio of a perimeter to a circumference of a smallest enclosing circle.

At step 2304, the predicted objects are grouped into groups based on the geometry shape. The classification/grouping of the predicted objects may utilize k-means for classifying the geometric feature data from the 2D geometric primitive geometries into objects. Further, the classification may determine an optimal number of classifications by evaluating results in the classifications within increasing k-values. In addition, the classification may use a silhouette algorithm to assess the quality of the classifications. Further, the classification may address premature iteration exit with a compactness-based judgment condition. Also, the classification process may enhance stability using an augmented Bikmeans algorithm that eliminates uncertainty from random sampling of an initial classification center.

Further step 2304 may perform the grouping by selecting a class/group from an existing library of classes, creating a new classification/group, selecting a class/group from the current drawing (e.g. accessing previous classifications by the user), etc.

At step 2306, the classified/grouped predicted objects are converted into blocks.

Steps 2302-2306 may also utilize fuzzy logic to mitigate position deviations caused by an absence or presence of geometries in the geometric feature data. Such fuzzy logic processing may: sort the predicted objects by length; scale the predicted objects to a target; compare a geometry type and the length between the target, and scale results of the comparing in order; and choose, based on the order, top-matched geometries to participate in alignment coordinate calculations.

### Smart Placement

Smart object placement provides for the automatic orientation of the block on placement utilizing a rule based algorithm. Such automatic orientation saves time for otherwise rotating and orienting blocks correctly for each instance.

Further to the above, embodiments of the invention may utilize a Block Placement Engine that is a geometry-based placement recommendation system for blocks. The engine learns the scenarios (of the existing instances of the being placed blocks) to infer the possible contexts and matches the learned context in the current scenario to get the possible placement recommendation. This engine may consist of two subsystems:
- Context Extractor: Obtains block context from the existing instance scenarios.
- Context Matcher: Finds the possible block context in the current scenario and provides the placement recommendation.

### Context Extractor

The context is the set of objects closely associated with a given block. It consists of meaningful geometric data with a fixed relative position and orientation to the associated blocks. Roughly, embodiments of the invention can get the possible block context by the following steps: sampling, analysis, and determining the context pattern.

### SAMPLING

A sampling of geometric data of objects around all existing instances of the block. The collected geometric data is coded and recorded for subsequent context analysis and extraction. Embodiments of the invention may use a group of concentric circles built on top of the local coordinate of the block instance to sample the geometric data around.

### ANALYSIS

Due to the differences in the contexts sampled by different block instances, all sample data needs to be further analyzed. Embodiments of the invention merge the sample data in which the sample points have the same distribution and remove the possible noisy data from them (noisy data are sample points that appear only in a particular sample).

### DETERMINE CONTEXT PATTERN

The set of sample points with the same location in the sample data and the geometric objects that have these sample points together form the "Context Pattern." There may be multiple instances of the same block in the current drawing, based on which one can extract multiple "Context Patterns" after sampling and analysis. By merging the same "Context Pattern," the final "Context Pattern" is unique.

### Context Matcher

Placement is about finding the context pattern around the cursor position with the being placed block instance. There are two approaches to finding the possible matched context pattern. Thereafter, based on the relationship between the block instances and the context pattern, the block instance is placed.

### GEOMETRY-BASED MATCHING

The geometry-based matching approach takes the current mouse position as the center of the circle, uses the radius of the circle surrounding the Context Pattern as the detection range, and looks for a combination of entities around the mouse that can match completely or partially with the geometry in the Context Pattern. When a possible Context Pattern is discovered, the current context is sampled for geometric data by using the same sampling method as the Context Pattern was generated. The sampled geometric data is then then compared to the sampling points in the Context Pattern to determine if the Context Pattern can be applied to the current location. Once established, the coordinate system of the current Context is calculated from the sampled points, and the rotation angle and position offset are calculated from the difference between the coordinate system and that of the Context Pattern.

### POSITION-BASED MATCHING

When the geometry in a Context Pattern is too simple (e.g., only a line or an arc), it may not be possible determine if the Context Pattern is applicable to the current context by looking up the matching geometry. Instead, embodiments of the invention back-calculate the center of the placed block from the position of the sampling point on the geometric object closest to the current mouse position. This position is then used as the center of the circle and the same sampling method is used as when the Context Pattern is generated to sample the current position. Thereafter, a determination is made regarding whether the Context Pattern is applicable to the current context by comparing whether the sampling points are matched or not.

### User Interface

As described above, the smart block functionality offers placement suggestions based on where a user has placed that block before in the drawing and may also replace specified block references by selecting from a palette of suggested similar blocks.

### BLOCK PLACEMENT

Automatic block placement capability may be provided for blocks inserted using a blocks palette to help the user place blocks more easily and save time. The block placement engine learns how the existing block instances are placed in a drawing to infer the next placement of the same block. As a user inserts a block from a Blocks palette to a drawing, the engine gives placement suggestions close to a similar geometry where the user has placed that block before.

For example, if the user has already placed a chair block close to the corner of a wall, when inserting another instance of that same chair block, embodiments of the invention automatically position the chair as the user moves it close to a similar corner. As the user moves the block, the walls may be highlighted, and the position, rotation, and scale of the chair block may be adjusted to match the other block instance. The user can click to accept the suggestion, press CTRL to switch to other suggestions, or move the cursor away to ignore the current suggestion. To temporarily turn off suggestions when placing a block, the user may hold Shift+W or Shift+[ while inserting or moving a block.

### BLOCK REPLACEMENT

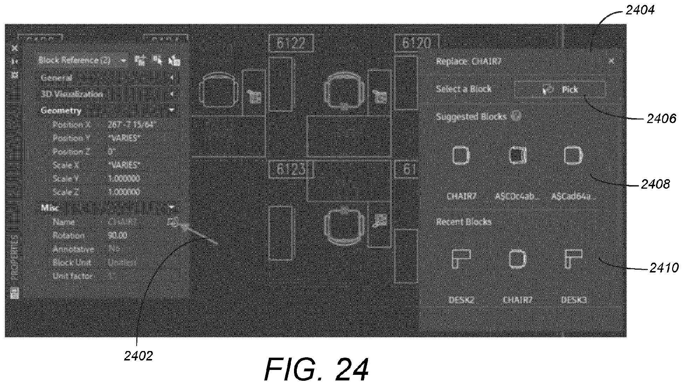

When a user selects block references to replace, embodiments of the invention may suggest similar blocks for the user to select from. The user may also replace the selected blocks with another block the user specifies from a drawing or from a list of recently inserted or created blocks (e.g., by selecting form a palette of suggested similar blocks). The replaced block reference may retain the scale, rotation, and attribute values of the original block. FIG. 24 illustrates an exemplary graphical user interface for performing block replacement in accordance with one or more embodiments of the invention. As illustrated, the user has clicked icon 2402 next to the block reference for the Chair7 and the dialog box 2404 has been displayed allowing the user to select a block at 2406 along with a list of suggested blocks 2408 and recently used blocks 2410. In other words, when a user has selected block references to replace, embodiments of the invention suggests similar blocks for the user to select from.

Further to the above, the first time the user completes a block replacement, a consent dialog may be displayed requesting access to the block data. Sharing the content data that is used during block replacement may then be used in a feedback loop to ML models to improve the block suggestions and other smart block functionality. Accordingly, block replacement uses ML algorithms to generate suggestions based on the block name and visual similarities of existing blocks (see the description above for similar block suggestions). ML may heavily rely on data, so insufficient block data may result in inaccurate suggestions. Accordingly, granting access to block data can help improve the accuracy of block suggestions. Furthermore, it may be noted that block suggestions can be based from the collections of block definitions stored in drawing files. In addition, adding more block libraries can provide more meaningful and relevant suggestions.

### Logical Flow

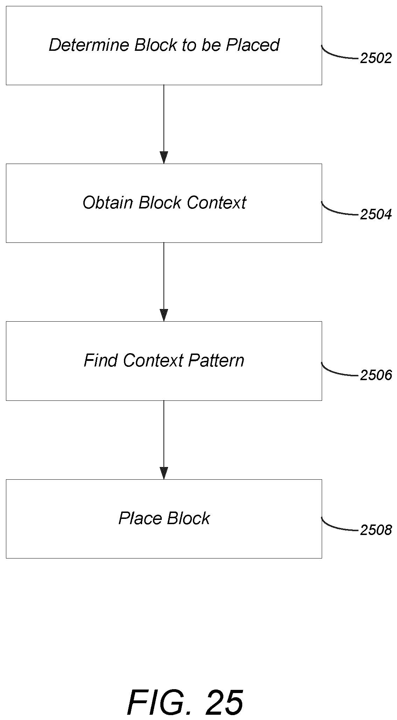

FIG. 25 illustrates the logical flow for placing/replacing a block in a computer aided design (CAD) application in accordance with one or more embodiments of the invention.

At step 2502, the block to be placed in a computer-aided design (CAD) drawing is determined. The block is a set of geometric objects.

At step 2504, a content extractor obtains block context from existing instances of the block in the CAD drawing. The block context includes: a set of objects associated with the block; geometric data, for the set of obj ects, with a fixed relative position and orientation with respect to the block; and a context pattern for geometric data for the set of objects.

The context extractor may obtain the block context by sampling, analyzing, and determining the context pattern. More specifically, the geometric data of objects for all existing instances of the block are sampled. The sampling codes and records the sampled geometric data for subsequent context analysis and extraction. The analysis examines the sampled geometric data by merging the sampled geometric data where the sample points have the same distribution. The context pattern is determined as a set of sample points with the same location and geometric data of objects that have the set of sample points.

At step 2506, a context matcher finds the context pattern around a cursor position with the block to be placed. To find the context pattern, embodiments of the invention may use geometry-based matching or position based matching.

For geometry based matching, the cursor position is taken as a center of a circle and a radius of the circle is used as a detection range. The content matcher then looks, within the detection range, for a combination of entities around the cursor position that can match with the geometric data in the context pattern. Upon discovering a match, a current context is sampled for geometric data and the sampled geometric data is compared to the set of sample points in the context pattern to determine if the context pattern can be applied to the cursor position. Once determining that the context pattern can be applied to the cursor position, a coordinate system of the current context is calculated, and a rotation angle and position offset is calculated from a difference between the coordinate system of the current context and a context pattern coordinate system.

For position based matching, a center of the block is back calculated to be placed from a position of a sampling point on the geometric data for one of the objects in the set objects that is closest to the cursor position. The back-calculated center is utilized as a circle center. A sampling method is then utilized to sample the cursor position. Lastly, a determination is made regarding whether the context pattern is applicable to a current context by comparing whether the sampled points of the cursor position are matched.

At step 2508, based on a relationship between the existing instances of the block and the context pattern, the block is placed in the CAD drawing.

### Hardware Environment

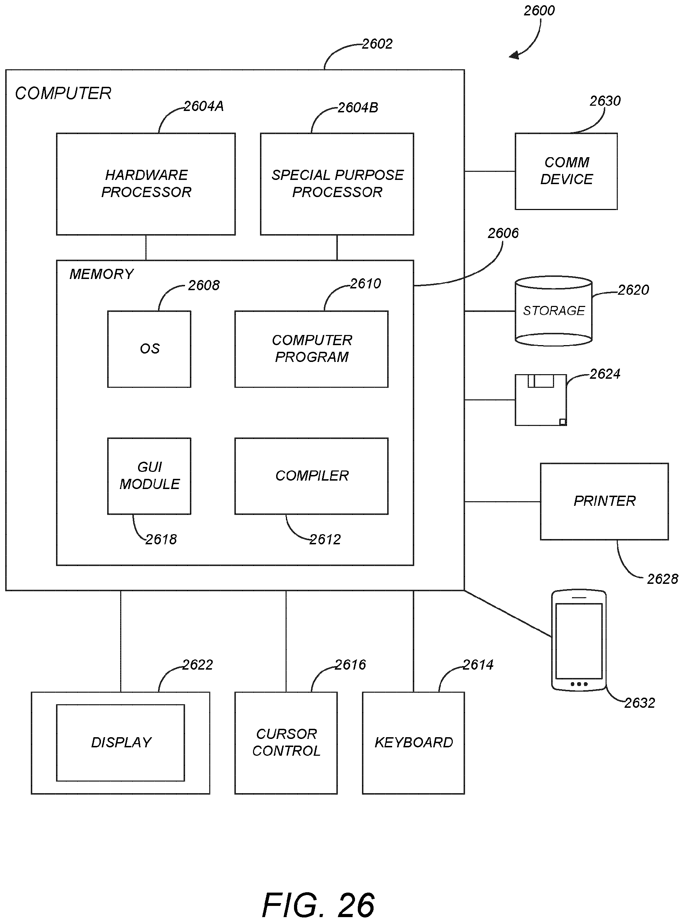

FIG. 26 is an exemplary hardware and software environment 2600 (referred to as a computer-implemented system and/or computer-implemented method) used to implement one or more embodiments of the invention. The hardware and software environment includes a computer 2602 and may include peripherals. Computer 2602 may be a user/client computer, server computer, or may be a database computer. The computer 2602 comprises a hardware processor 2604A and/or a special purpose hardware processor 2604B (hereinafter alternatively collectively referred to as processor 2604) and a memory 2606, such as random access memory (RAM). The computer 2602 may be coupled to, and/or integrated with, other devices, including input/output (I/O) devices such as a keyboard 2614, a cursor control device 2616 (e.g., a mouse, a pointing device, pen and tablet, touch screen, multi-touch device, etc.) and a printer 2628. In one or more embodiments, computer 2602 may be coupled to, or may comprise, a portable or media viewing/listening device 2632 (e.g., an MP3 player, IPOD, NOOK, portable digital video player, cellular device, personal digital assistant, etc.). In yet another embodiment, the computer 2602 may comprise a multi-touch device, mobile phone, gaming system, internet enabled television, television set top box, or other internet enabled device executing on various platforms and operating systems.

**In** one embodiment, the computer 2602 operates by the hardware processor 2604A performing instructions defined by the computer program 2610 (e.g., a computer-aided design [CAD] application) under control of an operating system 2608. The computer program 2610 and/or the operating system 2608 may be stored in the memory 2606 and may interface with the user and/or other devices to accept input and commands and, based on such input and commands and the instructions defined by the computer program 2610 and operating system 2608, to provide output and results.

Output/results may be presented on the display 2622 or provided to another device for presentation or further processing or action. In one embodiment, the display 2622 comprises a liquid crystal display (LCD) having a plurality of separately addressable liquid crystals. Alternatively, the display 2622 may comprise a light emitting diode (LED) display having clusters of red, green and blue diodes driven together to form full-color pixels. Each liquid crystal or pixel of the display 2622 changes to an opaque or translucent state to form a part of the image on the display in response to the data or information generated by the processor 2604 from the application of the instructions of the computer program 2610 and/or operating system 2608 to the input and commands. The image may be provided through a graphical user interface (GUI) module 2618. Although the GUI module 2618 is depicted as a separate module, the instructions performing the GUI functions can be resident or distributed in the operating system 2608, the computer program 2610, or implemented with special purpose memory and processors.

In one or more embodiments, the display 2622 is integrated with/into the computer 2602 and comprises a multi-touch device having a touch sensing surface (e.g., track pod, touch screen, smartwatch, smartglasses, smartphones, laptop or non-laptop personal mobile computing devices) with the ability to recognize the presence of two or more points of contact with the surface. Examples of multi-touch devices include mobile devices (e.g., IPHONE, ANDROID devices, WINDOWS phones, GOOGLE PIXEL devices, NEXUS S, etc.), tablet computers (e.g., IPAD, HP TOUCHPAD, SURFACE Devices, etc.), portable/handheld game/music/video player/console devices (e.g., IPOD TOUCH, MP3 players, NINTENDO SWITCH, PLAYSTATION PORTABLE, etc.), touch tables, and walls (e.g., where an image is projected through acrylic and/or glass, and the image is then backlit with LEDs).

Some or all of the operations performed by the computer 2602 according to the computer program 2610 instructions may be implemented in a special purpose processor 2604B. In this embodiment, some or all of the computer program 2610 instructions may be implemented via firmware instructions stored in a read only memory (ROM), a programmable read only memory (PROM) or flash memory within the special purpose processor 2604B or in memory 2606. The special purpose processor 2604B may also be hardwired through circuit design to perform some or all of the operations to implement the present invention. Further, the special purpose processor 2604B may be a hybrid processor, which includes dedicated circuitry for performing a subset of functions, and other circuits for performing more general functions such as responding to computer program 2610 instructions. In one embodiment, the special purpose processor 2604B is an application specific integrated circuit (ASIC).

The computer 2602 may also implement a compiler 2612 that allows an application or computer program 2610 written in a programming language such as C, C++, Assembly, SQL, PYTHON, PROLOG, MATLAB, RUBY, RAILS, HASKELL, or other language to be translated into processor 2604 readable code. Alternatively, the compiler 2612 may be an interpreter that executes instructions/source code directly, translates source code into an intermediate representation that is executed, or that executes stored precompiled code. Such source code may be written in a variety of programming languages such as JAVA, JAVASCRIPT, PERL, BASIC, etc. After completion, the application or computer program 2610 accesses and manipulates data accepted from I/O devices and stored in the memory 2606 of the computer 2602 using the relationships and logic that were generated using the compiler 2612.

The computer 2602 also optionally comprises an external communication device such as a modem, satellite link, Ethernet card, or other device for accepting input from, and providing output to, other computers 2602.

In one embodiment, instructions implementing the operating system 2608, the computer program 2610, and the compiler 2612 are tangibly embodied in a non-transitory computer-readable medium, e.g., data storage device 2620, which could include one or more fixed or removable data storage devices, such as a zip drive, floppy disc drive 2624, hard drive, CD-ROM drive, tape drive, etc. Further, the operating system 2608 and the computer program 2610 are comprised of computer program 2610 instructions which, when accessed, read and executed by the computer 2602, cause the computer 2602 to perform the steps necessary to implement and/or use the present invention or to load the program of instructions into a memory 2606, thus creating a special purpose data structure causing the computer 2602 to operate as a specially programmed computer executing the method steps described herein. Computer program 2610 and/or operating instructions may also be tangibly embodied in memory 2606 and/or data communications devices 2630, thereby making a computer program product or article of manufacture according to the invention. As such, the terms "article of manufacture," "program storage device," and "computer program product," as used herein, are intended to encompass a computer program accessible from any computer readable device or media.

Of course, those skilled in the art will recognize that any combination of the above components, or any number of different components, peripherals, and other devices, may be used with the computer 2602.

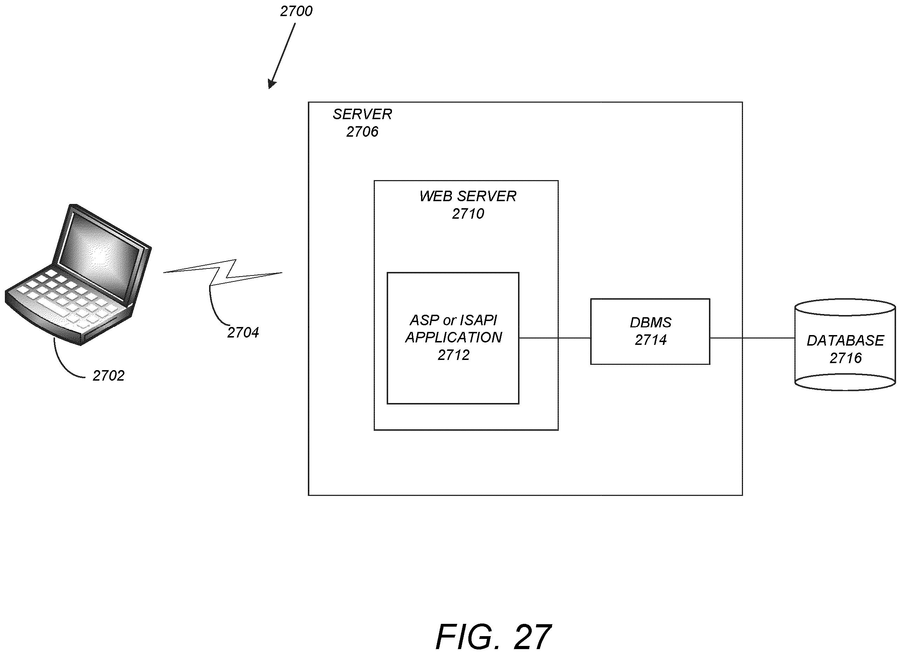

FIG. 27 schematically illustrates a typical distributed/cloud-based computer system 2700 using a network 2704 to connect client computers 2702 to server computers 2706. A typical combination of resources may include a network 2704 comprising the Internet, LANs (local area networks), WANs (wide area networks), SNA (systems network architecture) networks, or the like, clients 2702 that are personal computers or workstations (as set forth in FIG. 26), and servers 2706 that are personal computers, workstations, minicomputers, or mainframes (as set forth in FIG. 26). However, it may be noted that different networks such as a cellular network (e.g., GSM [global system for mobile communications] or otherwise), a satellite based network, or any other type of network may be used to connect clients 2702 and servers 2706 in accordance with embodiments of the invention.

A network 2704 such as the Internet connects clients 2702 to server computers 2706. Network 2704 may utilize ethernet, coaxial cable, wireless communications, radio frequency (RF), etc. to connect and provide the communication between clients 2702 and servers 2706. Further, in a cloud-based computing system, resources (e.g., storage, processors, applications, memory, infrastructure, etc.) in clients 2702 and server computers 2706 may be shared by clients 2702, server computers 2706, and users across one or more networks. Resources may be shared by multiple users and can be dynamically reallocated per demand. In this regard, cloud computing may be referred to as a model for enabling access to a shared pool of configurable computing resources.

Clients 2702 may execute a client application or web browser and communicate with server computers 2706 executing web servers 2710. Such a web browser is typically a program such as MICROSOFT INTERNET EXPLORER/EDGE, MOZILLA FIREFOX, OPERA, APPLE SAFARI, GOOGLE CHROME, etc. Further, the software executing on clients 2702 may be downloaded from server computer 2706 to client computers 2702 and installed as a plug-in or ACTIVEX control of a web browser. Accordingly, clients 2702 may utilize ACTIVEX components/component object model (COM) or distributed COM (DCOM) components to provide a user interface on a display of client 2702. The web server 2710 is typically a program such as MICROSOFT' S INTERNET INFORMATION SERVER.

Web server 2710 may host an Active Server Page (ASP) or Internet Server Application Programming Interface (ISAPI) application 2712, which may be executing scripts. The scripts invoke objects that execute business logic (referred to as business objects). The business objects then manipulate data in database 2716 through a database management system (DBMS) 2714. Alternatively, database 2716 may be part of, or connected directly to, client 2702 instead of communicating/obtaining the information from database 2716 across network 2704. When a developer encapsulates the business functionality into objects, the system may be referred to as a component object model (COM) system. Accordingly, the scripts executing on web server 2710 (and/or application 2712) invoke COM objects that implement the business logic. Further, server 2706 may utilize MICROSOFT' S TRANSACTION SERVER (MTS) to access required data stored in database 2716 via an interface such as ADO (Active Data Objects), OLE DB (Object Linking and Embedding DataBase), or ODBC (Open DataBase Connectivity).

Generally, these components 2700-2716 all comprise logic and/or data that is embodied in/or retrievable from device, medium, signal, or carrier, e.g., a data storage device, a data communications device, a remote computer or device coupled to the computer via a network or via another data communications device, etc. Moreover, this logic and/or data, when read, executed, and/or interpreted, results in the steps necessary to implement and/or use the present invention being performed.

Although the terms "user computer", "client computer", and/or "server computer" are referred to herein, it is understood that such computers 2702 and 2706 may be interchangeable and may further include thin client devices with limited or full processing capabilities, portable devices such as cell phones, notebook computers, pocket computers, multi-touch devices, and/or any other devices with suitable processing, communication, and input/output capability.

Of course, those skilled in the art will recognize that any combination of the above components, or any number of different components, peripherals, and other devices, may be used with computers 2702 and 2706. Embodiments of the invention are implemented as a software/CAD application on a client 2702 or server computer 2706. Further, as described above, the client 2702 or server computer 2706 may comprise a thin client device or a portable device that has a multi-touch-based display.

### Conclusion

This concludes the description of the preferred embodiment of the invention. The following describes some alternative embodiments for accomplishing the present invention. For example, any type of computer, such as a mainframe, minicomputer, or personal computer, or computer configuration, such as a timesharing mainframe, local area network, or standalone personal computer, could be used with the present invention.

In summary, embodiments of the invention provide smart block capability that enhances block management in drawings. Smart Blocks simplifies the creation, editing, and manipulation of blocks. By analyzing the drawing context and patterns using ML algorithms, Smart Blocks offers a range of intelligent features. These features include automatic block placement, block replacement, block conversion, and object detection. Such features provide a valuable tool that improves efficiency and productivity by automating repetitive tasks and simplifying block handling. Furthermore, it enhances workflow and saves time, whether a user is working on architectural designs or any other type of project.

The foregoing description of the preferred embodiment of the invention has been presented for the purposes of illustration and description. It is not intended to be exhaustive or to limit the invention to the precise form disclosed. Many modifications and variations are possible in light of the above teaching. It is intended that the scope of the invention be limited not by this detailed description, but rather by the claims appended hereto.

## Claims

1. A computer-implemented method for providing similar computer aided design (CAD) blocks, comprising:
(a) training a shape similarity machine learning (ML) model based on labeled images, wherein:
(i) the labeled images comprise blocks from architectural and engineering industries;
(ii) each labeled image comprises a class label;
(iii) the shape similarity model groups blocks together based on shape using the class label to guide learning;
(b) fine tuning a name similarity ML model based on block metadata information extracted from one or more drawing files wherein the name similarity model groups blocks together based on name;
(c) receiving a block query for a block, wherein the block query comprises:
(i) a raster-based block image; and
(ii) metadata information associated with the block;
(d) the shape similarity model processing the raster-based block image to output shape embeddings;
(e) the name similarity model processing the metadata information associated with the block to output name embeddings;
(f) a suggestion engine combining the shape embeddings and the name embeddings to identify similar blocks; and
(g) providing the identified similar blocks in response to the block query.

2. The computer-implemented method of claim 1, wherein:
the metadata comprises: a block name, a drawing name, and a file path; and/or
the shape similarity model processes the raster-based block image using an encoder that extracts features from the labeled images.

3. The computer-implemented method of claim 1 or claim 2, wherein:
the shape similarity model is generated using a convolutional neural network (CNN); and
the name similarity model is generating using a transformer model.

4. The computer-implemented method of any of claims 1-3, wherein the suggestion engine:
orders the identified similar blocks based on similarity;
selects, based on the order, a defined number of most relevant identified similar blocks; and
provides the defined number of most relevant identified similar blocks in response to the block query.

5. A computer-implemented method for detecting computer aided design (CAD) objects, comprising:
(a) training a machine-learning (ML) to process graphs representing the CAD objects, wherein:
(b) obtaining a CAD drawing comprising two-dimensional (2D) geometric primitive geometries;
(c) representing the CAD drawing as an input graph, wherein:
(i) the 2D geometric primitive geometries are represented by geometric tokens in nodes of the input graph;
(ii) spatial KNN (k nearest neighbor) adjacency between the 2D geometric primitive geometries are represented as edges between the nodes of the input graph;
(d) processing the input graph in the ML model, wherein the ML model outputs nodes representing predicted objects for the 2D geometric primitive geometries;
(e) utilizing the predicted objects to represent the 2D geometric primitive geometries; and
(f) consolidating the predicted objects to create a new labeled drawing.

6. The computer-implemented method of claim 5, wherein:
the ML model uses a sparse transformer model as an encoder, and the sparse transformer model encodes the geometric tokens and positional embeddings into object representations and geometry representations; and/or
the ML model is updated via a feedback loop based on confirmation of the predicted objects from user input.

7. The computer-implemented method of claim 5 or claim 6, further comprising:
preparing, from the predicted objects, geometric feature data;
grouping the predicted objects into classifications based on the geometric feature data;
converting the classified predicted objects into blocks.

8. The computer-implemented method of claim 7, wherein the preparing the geometric feature data comprises:
increasing a number of sampling vertices on geometries;
utilizing principal component analysis (PCA) computation using all the sampling vertices for Eigenvalue calculations; and
including a length of the 2D geometric primitive geometries and a ratio of a perimeter to a circumference of a smallest enclosing circle.

9. The computer-implemented method of claim 7 or claim 8, wherein the grouping the predicted objects comprises:
utilizing k-means for classifying the geometric feature data from the 2D geometric primitive geometries into classifications;
determining an optimal number of classifications by evaluating results in the classifications within increasing k-values;
using a silhouette algorithm to assess a quality of the classifications;
addressing premature iteration exit with a compactness-based judgment condition; and
enhancing stability using an augmented Bikmeans algorithm that eliminates uncertainty from random sampling of an initial classification center.

10. The computer-implemented method of any of claims 7-9, further comprising:
utilizing fuzzy logic to mitigate position deviations caused by an absence or presence of geometries in the geometric feature data.

11. The computer-implemented method of claim 10, wherein the utilizing fuzzy logic comprises:
sorting the predicted objects by length;
scaling the predicted objects to a target;
comparing a geometry type and the length between the target, and scaling results of the comparing in order; and
choosing, based on the order, top-matched geometries to participate in alignment coordinate calculations.

12. A computer-implemented method for placing a block in a computer aided design (CAD) drawing, comprising:
(a) determining the block to be placed in the computer-aided design (CAD) drawing, wherein the block comprises a set of geometric objects;
(b) a content extractor obtaining block context from existing instances of the block in the CAD drawing, wherein block context comprises:
(i) a set of objects associated with the block;
(ii) geometric data, for the set of obj ects, with a fixed relative position and orientation with respect to the block;
(iii) a context pattern for geometric data for the set of objects;
(c) a context matcher that finds the context pattern around a cursor position with the block to be placed; and
(d) based on a relationship between the existing instances of the block and the context pattern, placing the block in the CAD drawing.

13. The computer-implemented method of claim 12, wherein the context extractor obtains the block context by:
sampling the geometric data of objects for all existing instances of the block, wherein the sampling codes and records the sampled geometric data for subsequent context analysis and extraction;
analyzing the sampled geometric data by merging the sampled geometric data where sample points have a same distribution; and
determining the context pattern comprising a set of sample points with a same location and geometric data of objects that have the set of sample points.

14. The computer-implemented method of claim 12 or claim 13, wherein the context matcher finds the context pattern using geometry based matching comprising:
taking the cursor position as a center of a circle;
using a radius of the circle as a detection range;
looking, within the detection range, for a combination of entities around the cursor position that can match with the geometric data in the context pattern;
upon discovering a match, sampling a current context for geometric data and comparing the sampled geometric data to the set of sample points in the context pattern to determine if the context pattern can be applied to the cursor position;
once determining that the context pattern can be applied to the cursor position, calculating a coordinate system of the current context; and
calculating a rotation angle and position offset from a difference between the coordinate system of the current context and a context pattern coordinate system.

15. The computer-implemented method of any of claims 12-14, wherein the context matcher finds the context pattern using position based matching comprising:
back calculating a center of the block to be placed from a position of a sampling point on the geometric data for one of the objects in the set objects that is closest to the cursor position;
utilizing the back-calculated center as a circle center;
utilizing a sampling method to sample the cursor position; and
determining whether the context pattern is applicable to a current context by comparing whether the sampled points of the cursor position are matched.
